Europäisches Patentamt

(19) European Patent Office

Office européen des brevets

(11) Publication number: **0 213 972**
**A1**

# (12) EUROPEAN PATENT APPLICATION

(21) Application number: **86401086.3**

(22) Date of filing: **22.05.86**

(51) Int. Cl.⁴: **H 01 L 21/265**
**H 01 L 29/78**

(30) Priority: **30.08.85 US 771444**

(43) Date of publication of application:
**11.03.87 Bulletin 87/11**

(84) Designated Contracting States:
**BE DE FR GB IT NL**

(71) Applicant: **SILICONIX INCORPORATED**
**2201 Laurelwood Road**
**Santa Clara California 95054 (US)**

(72) Inventor: **Blanchard, Richard A.**
**10724 Mora Dr.**
**Los Altos, CA 94022 (US)**

**Williams, Richard K.**
**10292 Norwich Ave.**
**Cupertino, CA 95014 (US)**

**Plummer, James D.**
**1940 Mt. Vernon Ct. No 16**
**Mt. View CA 94040 (US)**

(74) Representative: **Martin, Jean-Jacques et al**
**Cabinet REGIMBEAU 26, Avenue Kléber**
**F-75116 Paris (FR)**

(54) **Method for shifting the threshold voltage of DMOS transistors.**

(57) A method for shifting the threshold voltage of a DMOS transistor includes the step of implanting positive ions in the gate insulation. In one embodiment of the invention, silicon dioxide is used as the gate insulation and ions are implanted therein. The ions retain their charge after implantation, and provide an electric field which lowers the threshold voltage of the DMOS transistor. In other embodiments of the invention, negative ions are implanted into the gate dielectric to raise the threshold voltage. The disclosed process thus permits control over the DMOS transistor threshold voltage without degrading breakdown or leakage characteristics. The variation of threshold voltage with Cs· ion implantation dosage is shown in the graph.

FIG.4

**Description**

# METHOD FOR SHIFTING THE THRESHOLD VOLTAGE OF DMOS TRANSISTORS

BACKGROUND OF THE INVENTION

This invention relates to MOS transistors and more specifically to methods for shifting the threshold voltage of double diffused MOS ("DMOS") transistors during the manufacturing process.

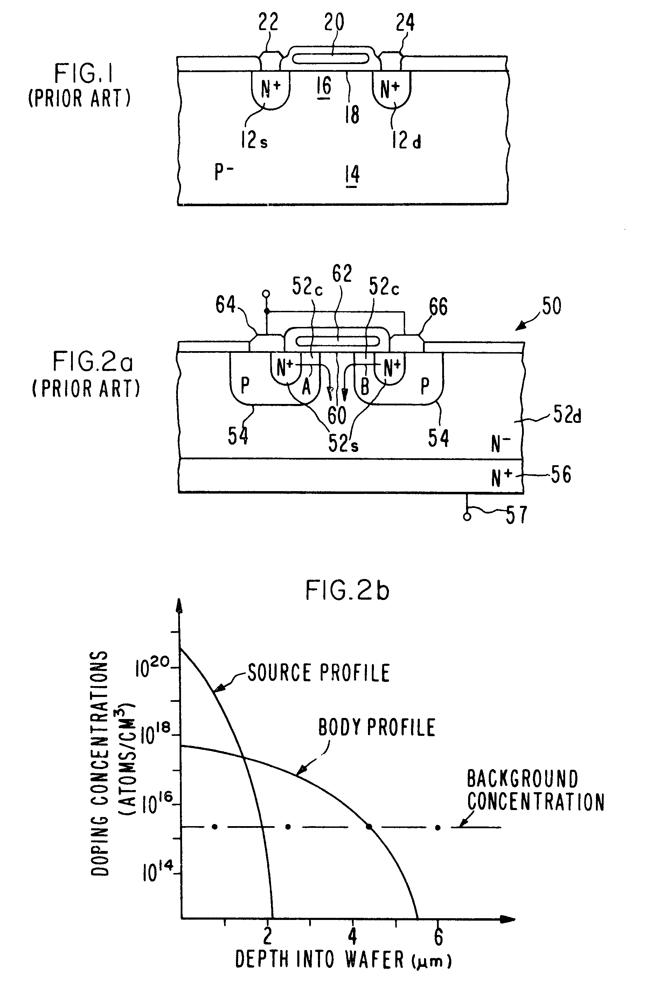

MOS transistors are well known in the art. A conventional MOS transistor is illustrated in cross section in Figure 1. Referring to Figure 1. N channel MOS ("NMOS") transistor 10 includes an N+ source 12s and an N+ drain 12d formed in a P-type substrate 14. A channel region 16 exists between source 12s and drain 12d. Above channel 16 is a layer of insulating material such as silicon dioxide 18 and above silicon dioxide layer 18 is a gate conductor 20 composed of a material such as aluminum or polycrystalline silicon. As is known in the art, if a voltage is applied to drain 12d relative to the voltage present at source 12s, no current will flow from drain 12d to source 12s unless there is a voltage present at gate conductor 20 greater than the threshold voltage of transistor 10.

A variety of methods exist for modifying the threshold voltage of a transistor such as transistor 10 during the fabrication of the transistor. This is done to enable the designer to provide MOS transistors having threshold voltages tailored to specific applications. For example, il is known in the art to use ion implantation to introduce dopants in the channel region of a transistor. This process is described in greater detail in US-E-29,660 issued to William E. Armstrong, which is hereby incorporated by reference. It is also known in the art to adjust the threshold voltage of MOS transistors by annealing wafers in oxygen instead of nitrogen during the final high temperature process steps. This increases the fixed charge per unit area at the silicon-silicon dioxide interface above the channel which decreases the threshold voltage of the transistor. It is also known in the art to use silicon having a [111] crystal orientation, which produces a greater charge at the silicon-silicon dioxide interface than devices fabricated using silicon having a [100] orientation Techniques used to adjust the threshold voltage of a conventional low voltage (i.e., less than 20 volts) MOS transistor provide a threshold shift in the range indicated in Table I for transistors having 100 nm thick silicon dioxide as a gate dielectric.

## TABLE I

| Method for Shifting Threshold Voltage | Amount of Voltage Shift in Conventional Transistor |
|---|---|
| Ion Implantation in Silicon* | $\Delta V_{TH} = 0$ to $\pm 2$ volts |
| Anneal | $\Delta V_{TH} = 0$ to $- 2$ volts |
| Using [100] crystal orientation vs. a [111] orientation | $\Delta V_{TH} = 0$ to $2$ volts |

\* Changes leakage (i.e., the current that flows through transistor when it is off) and breakdown voltage.

One variation of the MOS transistor is the DMOS transistor, which is typically used in high current (i.e., up to 200 A) and high voltage (i.e., up to 1000 V) applications. (As is known in the art, a DMOS transistor is one in which the difference in the diffusion of sequentially introduced impurities from a common edge or boundary is used to define the channel length.) Figure 2a is an illustration in cross section of a vertical DMOS transistor 50 constructed in accordance with the prior art. DMOS transistors operate in a manner similar to that of conventional MOS transistors with minor variations. DMOS transistor 50 includes N+ sources 52s formed within a pair of P regions 54 and 56 (the body region of transistor 50), which in turn are formed within an N- drain region 52d which in turn is formed on an N+ region 56 coupled to a drain lead 57. Although regions 54 and 56 appear as two separate regions, they are actually a single contiguous region joined behind the plane of the cross section, as is region 52s. Extending above N- drain region 52d, P regions 54 and 56 and N+ source 52s is a layer of insulating material such as silicon dioxide layer 60. Above insulating layer 60 is a gate 62 formed from polycrystalline silicon or aluminum. In operation, when a positive voltage greater than the threshold voltage of transistor 50 is applied to gate 62, current carriers (electrons in an N-channel device) are permitted to flow from source regions 52s to drain 52d in the direction indicated by arrows A and B when a positive voltage is present at the drain.

Transistors such as transistor 50 have been found to be particularly appropriate for high voltage-high current applications because the channel length of DMOS transistors can be controlled within a narrower range of values than in conventional MOS fabrication. (The channel length is controlled with precision because, as described above, it is determined by the difference between sequential diffusions from a common boundary or point of origin.) This is important because the transconductance of the transistor is approximately inversely proportional to channel length as is the on-resistance contributed by the channel region. In a DMOS transistor, because N- region 52d (which forms part of the drain) is less heavily doped than channel 52c, when reverse biased, the depletion region between channel 52c and drain 52d extends further into N- drain 52d than into channel 52c, thus affecting channel length to a lesser extent than if the channel 52c and drain 52d were doped with equal concentrations. (As is known in the art, the channel-drain junction is reverse biased when transistor 50 is off and the voltage at drain 52d is greater than the voltage at channel 52c. The depletion region is the region between drain 52d and channel 52c, when reverse biased, in which holes and conduction electrons are removed by the reverse bias voltage.) Because of this behaviour, a high drain voltage can be withstood without depleting through body region 54, 56 to source 52s, which would result in a phenomenon called punch through breakdown.

DMOS transistors require a graded doping profile along the channel region between the source and drain which is different from the doping profile in a conventional low voltage MOS transistor. A graded doping profile is a nonuniform doping profile such as the one illustrated in the graph of Figure 2b. A typical DMOS doping concentration required in the body region to withstand large reverse bias voltages on the drain regions also determines the threshold voltage for the device. For low voltage (i.e., less than 100 volts) DMOS transistors, a threshold voltage of approximately 1 volt may be obtained by conventional process control before appreciable subthreshold current occurs. (Subthreshold current is the current that occurs at gate voltage below the calculated threshold voltage. This current increases rapidly as the threshold voltage approaches zero volt.)

For a prior art vertical DMOS transistor with a typical threshold voltage of 2 to 4 volts a threshold voltage shift of less than 6 volts can be obtained using the methods indicated in Table I. The use of ion implantation to alter the doping profile in a channel region has been experimentally found to decrease the breakdown voltage of DMOS transistors. The threshold shift that may be obtained without using the implant technique is approximately 4 volts which is not sufficient to produce desired depletion mode characteristics, i.e., to shift the threshold voltage below zero volt. (As is known in the art, a depletion mode transistor is one which is normally on, and requires application of a negative voltage, for N-channel devices, to turn it off.) Accordingly, if it is desired to produce a DMOS transistor having a negative threshold voltage, i.e., a depletion mode DMOS transistor, an alternative method must be used to reduce the threshold voltage.

## SUMMARY

A process for shifting the threshold voltage of a DMOS transistor in accordance with the present invention includes the step of implanting ions in the gate dielectric which remain either positively or negatively charged after implantation and subsequent processing steps. In one embodiment of the invention, cesium ions (which are positive ions) are used to shift the threshold voltage of the DMOS transistor in a negative direction. These ions retain their charge while implanted in the gate dielectric because they are surrounded by insulating material. In other embodiments of the invention, iodine ions (which are negative ions) are used to shift the threshood voltage in a positive direction. The choice of ions, the dosage, the implant energy and various parameters of the gate dielectric determine the change in threshold voltage. In this way, it is possible to accurately control the threshold voltage of a DMOS transistor. By implanting ions into the gate dielectric, it is possible to shift the threshold voltage of a DMOS transistor to a greater extent than the above-mentioned prior art techniques without altering the breakdown or leakage characteristics of the DMOS transistor.

## BRIEF DESCRIPTION OF THE DRAWINGS

Figure 1 is a cross section diagram of a conventional MOS transistor.
Figure 2a is a cross section diagram of a conventional DMOS transistor.
Figure 2b is a graph of the doping profile of the transistor of Figure 2a.
Figures 3a through 3e are cross section diagrams of a transistor during various processing steps in accordance with the present invention.
Figure 4 is a graph of threshold voltage shift versus cesium ion implantation dosage.

## DETAILED DESCRIPTION OF THE INVENTION

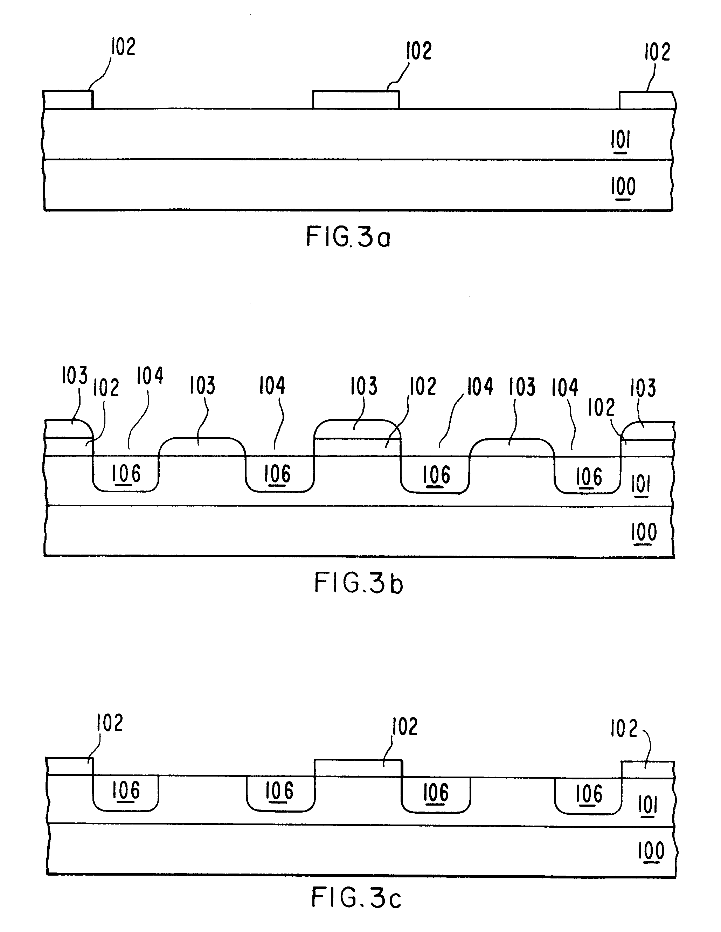

Referring to Figure 3a, an N type epitaxial layer 101 is deposited on an N+ substrate 100. In one embodiment of the invention, epitaxial layer 101 has a conductivity within the range of 0.5 and 30 ohm.centimeter and substrate 100 has a conductivity within the range of .005 and 0.1 ohm.centimeter. A layer of silicon dioxide 102 is then formed on epitaxial layer 101. Silicon dioxide layer 102 is typically 300 to 800 nm thick, and is formed by a thermal oxidation process, e.g., by heating the wafer in oxygen at approximately 1050 to 1200 °C for approximately 3 to 6 hours, or in water vapor at 900 to 1100°C for 0.5 to 2 hours. Silicon dioxide layer 102 is then patterned to expose the active areas of the to-be-formed DMOS transistor using conventional techniques (e.g.. covering with photoresist, patterning the photoresist to expose portions of silicon dioxide layer 102, and etching the exposed portions using, e.g., buffered HF), leaving the structure illustrated in Figure 3a.

Referring to Figure 3b, the wafer is then covered with a layer of photoresist 103 which is patterned in a well known manner in expose portions 104 of epitaxial layer 101 which are to become the deep body or P+ regions 106 of the DMOS transistor. The wafer is then subjected to an ion implantation process in which P+ regions 106 are formed. (In other embodiments of the invention, deep body regions 106 can be formed via other techniques.) In this process, boron ions having an energy of 20 to 200 keV are implanted to a dosage within the range of approximately $10^{13}$ to $10^{15}/cm^2$. Thereafter, as shown in Figure 3c, remaining portions of photoresist layer 103 are removed, and deep body region 106 is diffused to a desired junction depth, typically 3 to 5 micrometers, for example, by diffusing the wafer for approximately 4 to 12 hours at approximately 1100 to 1200 C in oxygen or an inert gas, such as nitrogen.

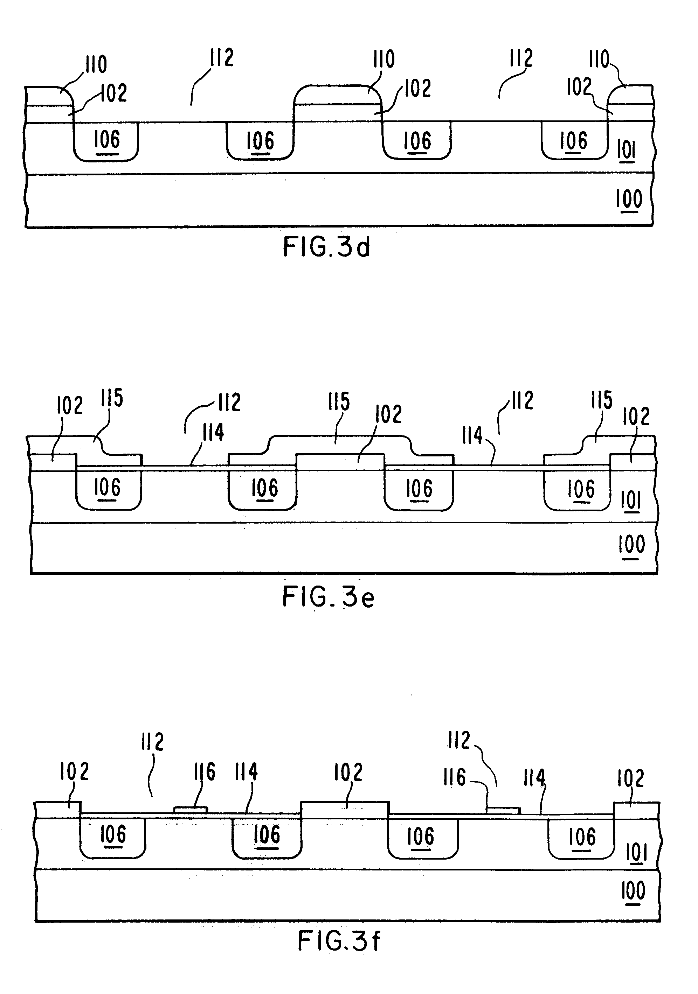

Referring to Figure 3d, a new layer of photoresist 110 is deposited on the wafer. Photoresist layer 110 is patterned in a well known manner in order to expose active regions 112. Active regions 112 are etched to remove all silicon dioxide which may have been formed on the surface of active regions 112 during the previous processing steps via a wet etching process using buffered HF, or a plasma etch process. After that, photoresist layer 110 is removed.

A 50 to 100 nm thick layer of silicon dioxide 114 is then formed on active area 112 as illustrated in Figure 3e, for example by thermal oxidation at approximately 900 to 1100°C for approximately 0.5 to 2.0 hours in an oxygen atmosphere. In one embodiment of the invention, silicon dioxide layer 114 forms the gate dielectric of the to-be-formed DMOS transistors. In other embodiments of the invention, silicon dioxide layer 114 is combined with an overlying layer of silicon nitride (not shown) to form the gate dielectric. In any event, the wafer is then covered with a photoresist layer 115 which is patterned to expose those portions of gate dilectric layer 114 where it is desired to implant threshold voltage-adjusting ions, as will hereinafter be described. In other embodiments, photoresist layer 115 is not used and the wafer is left blank prior to the introduction of the threshold adjusting species by ion implantation.

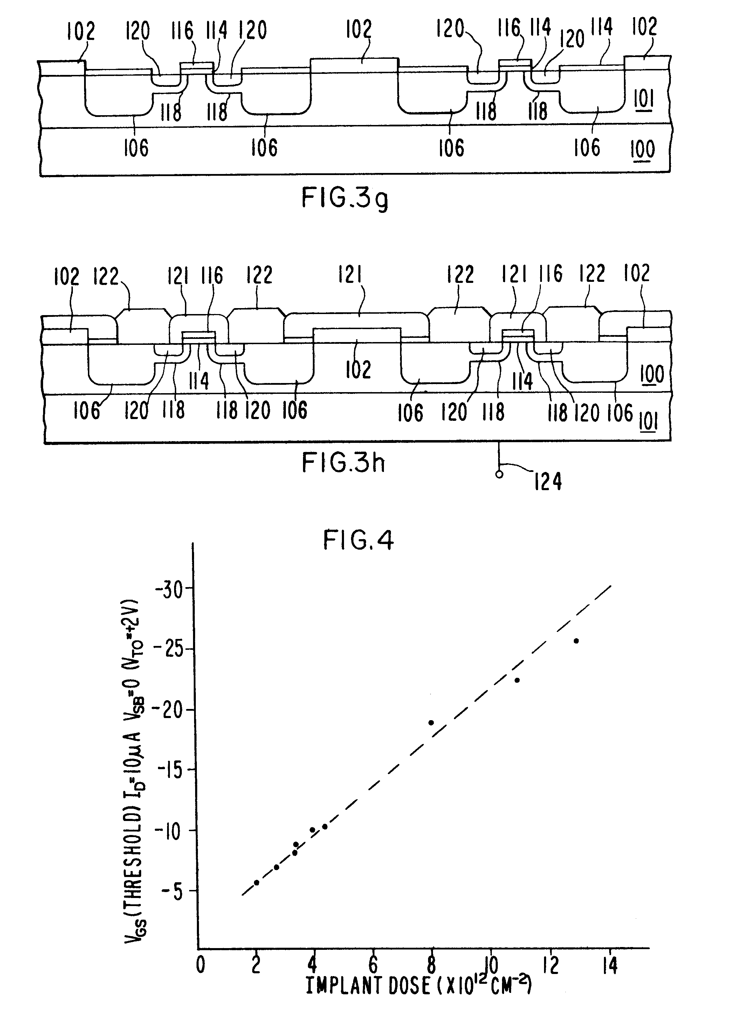

The wafer is then subjected to an ion implantation process in which ions ae implanted into silicon dioxide layer 114. If mask layer 115 is used, the ions are only implanted into that portion of gate dielectric 114 exposed by mask 115. If mask 115 is not used, the ions are deposited into oxide layers 114 and 102 across the wafer. As mentioned above, the implanted ions retain their charge after implantation because they are surrounded by insulating material and move very slowly through silicon dioxide layer 114, even at high temperatures. The ions alter the threshold voltage of the transistor being fabricated. In one embodiment of the invention, positive ions are implanted into silicon dioxide layer 114 which decreases the threshold voltage for the to-be-formed N channel DMOS transistor. This is because the postiive ions provide a constant electric field above the channel region, inducing an equal but opposite charge in the channel region. In other embodiment of the invention, negative ions are implanted in silicon dioxide layer 114, thus increasing the threshold voltage of the to-be-formed transistor. (For P channel DMOS transistors, positive ions decrease the threshold voltage and negative ions increase the threshold voltage.) In one embodiment of the invention, positive cesium ions are implanted to a dosage of approximately $2 \times 10^{12}$ to $7 \times 10^{12}/cm^2$ with an implant energy of within the range of approximately 40 keV to 150 KeV, decreasing the threshold voltage by 5 to 15 volts. In this way, an alternative method of modifying the threshold voltage of a transistor is provided which does not require changing the doping profile of the transistor, and therefore does not alter the breakdown and leakage characteristics of the transistor. Further, it has been found that it is possible to change the transistor threshold voltage by as much as 60 volts using this technique - a shift greater than that which can be achieved using other prior art techniques. Figure 4 is a graph of dose versus threshold voltage shift when cesium ions are used. In other embodiments of the invention, negatively charged iodine ions are implanted which increase the threshold voltage of the transistor by providing a negative electrical charge above the channel of the transistor. As mentioned above, other ions, both positively and negatively charged, can be used as well.

Thereafter, mask 115 (if used) is removed. A layer of polycrystalline silicon 116 (Figure 3f) is then formed on the wafer surface to a thickness of approximately 400 to 600 nm, for example by chemical vapor deposition, and is doped to increase its conductivity to within the range of approximately 30 and 60 ohms per square, for example using phosphorus as the dopant. Polycrystalline silicon layer 116 is then patterned and etched by conventional techniques, e.g., covering the wafer with photoresist, patterning the photoresist to expose those portions of the wafer where polycrystalline silicon layer 116 is not desired, and etching the exposed portions of polycrystalline silicon layer 116, for example, using a plasma etching process. The photoresist is then removed, leaving polycrystalline silicon gate structures 116 as illustrated.

Referring to Figure 3g, the dielectric layer in active region 112 above where body region 118 is to be formed is etched using conventional techniques, e.g., covering the wafer with photoresist, patterning the photoresist to expose portions of silicon dioxide layer 114, etching the exposed portions of silicon dioxide layer 114, and removing the photoresist. (It is also possible to perform the etch step without the presence of photoresist at this process step, depending on prior process steps.) Body region 118 is then formed, for example, by implanting and diffusing a dopant such as boron. In one embodiment of the invention, the boron is implanted to a dosage in the range of approximately $10^{13}/cm^2$ and $2 \times 10^{14}/cm^2$ using an implant energy of within the range of 40 and 120 keV. The boron is then diffused for example by heating the wafer at a temperature of approximately 1100 to 1200 C for approximately 4 to 12 hours in an oxygen or a nitrogen atmosphere.

The wafer is then subjected to an ion implantation process in which arsenic or phosphorus ions are implanted with an energy of approximately 50 to 150 keV to a dosage within the range of $5 \times 10^{14}$ and $5 \times 10^{15}$ ions per $cm^2$ to form source regions 120. No additional mask is used during the source ion implantation process as silicon dioxide layer 114 serves as the mask during this step. The implanted arsenic or phosphorus is then diffused to a desired depth, e.g., 1 to 3 μm. In one embodiment of the invention, source regions 120 are diffused by heating the wafer to approximately 1000 to 1150°C for approximately 0.5 to 3.0 hours in an oxygen or a nitrogen atmosphere.

The wafer can then be covered with an insulating silicon dioxide layer 121 as illustrated in Figure 3h, e.g., by a chemical vapor deposition process if a sufficiently thick silicon dioxide layer was not grown over the wafer during source diffusion. Contacts are then opened to source 120 and body regions 106 and gate region 116 on the top surface and a layer of metal 122 (typically aluminum or an aluminum alloy 1 to 4 μm thick) is deposited. e.g., by sputtering, to form electrical contacts to the top surface of the device as illustrated in Figure 3h. The point where metal layer 122 contacts gate 116 is not in the plane of illustration and is therefore not shown in Figure 3h. Metal layer 122 is then masked with photoresist, which is then patterned to expose those portions where it is desired to remove metal layer 122. Metal layer 122 is then etched, leaving the structure as illustrated in Figure 3h. As mentioned above, under N- epitaxial layer 101 is N+ substrate 100 which extends to the bottom surface of the silicon wafer. This region is used to form a drain contact 124.

The above-described process permits a change in threshold voltage of a DMOS transistor without degrading its breakdown characteristics. In addition, unlike conventional ion implantation processes, the above-mentioned process do not degrade the leakage characteristics of the DMOS transistor either.

For some applications, e.g. telecom applications, the above-described process is used to form DMOS transistors having a threshold voltage between -2 and -4 volts. For other applications, e.g. current source applications, the process is used to provide DMOS transistors with a threshold voltage between -4 and -8 volts. The process can be used to provide DMOS transistors with other threshold voltages as well.

While the invention has been described with respect to specific embodiments, those skilled in the art will recognize that minor modifications can be made in form and substance without departing from the spirit and scope of the invention. For example, enhancement mode or depletion mode transistors could be fabricated using the process of the present invention. In addition, this process could be used in the fabrication of both P channel and N channel devices. Accordingly, all such modifications come within the scope of the invention. One such modification is to align the source and body dopant introduction steps to a common edge (not the gate electrode) such as from a silicon dioxide region, or a region of another material.

**Claims**

1. A method for manufacturing a DMOS transistor characterized by the step of providing charged ions in a layer of gate insulation.

2. The method of Claim 1 further characterized in that said ions are cesium ions.

3. The method of Claim 1 further characterized in that said ions are iodine ions.

4. The method of Claim 1 further characterized in that said layer of insulation comprises a silicon dioxide layer.

5. The method of Claim 1 further characterized in that said layer of insulation comprises a silicon nitride layer formed over a silicon dioxide layer.

6. The method of Claim 1 further characterized by comprising the step of providing a polycrystalline silicon gate above the layer of gate insulation.

7. The method of Claim 1 further characterized by comprising the steps of :
providing a substrate having a first conductivity type ;
forming a first well region within said substrate having a second conductivity type opposite that of said substrate :
forming a second well region within said first well region having said first conductivity rype : and
providing a gate, said gate extending above said substrate and said first and second wells.

8. A DMOS transistor including a channel region, a layer of insulation above said channel region, and a gate region above said channel region, said transistor characterized by comprising a concentration of charged ions within said layer of insulation, whereby said charged ions alter the threshold voltage of said DMOS transistor.

9. The DMOS transistor of Claim 8 further characterized in that said ions are cesium.

10. The DMOS transistor of Claim 8 further characterized in that said ions are iodine.

11. The DMOS transistor of Claim 8 further characterized by comprising a source region adjacent said channel region and a drain region adjacent said channel region.

FIG.1
(PRIOR ART)

FIG.2a
(PRIOR ART)

FIG.2b

102                    102                    102

101

100

FIG.3a

103 102  104   103   104      103 102   104  103  104    102  103

106        106         106         106       101

100

FIG.3b

102              102              102

106        106        106        106    101

100

FIG.3c

FIG.3d

FIG.3e

FIG.3f

FIG.3g

FIG.3h

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int Cl.⁴) |
|---|---|---|---|
| X | US-A-3 328 210 (J. McCALDIN)<br><br>* figure 2; column 1, lines 22-30, 35, 52; column 2, lines 44-67; column 4, lines 55-56; claim 1 * | 1-4,8-11 | H 01 L 21/265<br>H 01 L 29/78 |
| X | DE-A-2 933 455 (PLESSEY HANDEL UND INVESTEMENTS)<br><br>* claims 1, 7, 10, 12, 13; page 10, paragraphs 2, 3; page 13, paragraph 2, last sentance; figure 1 * | 1,2,4,6,8,9,11 | |
| A | | 5 | |
| X | DE-A-2 530 730 (IBM)<br><br>* page 6, paragraphs 2, 3; claims 2, 3; figure 3 * | 1,4,6,8,11 | TECHNICAL FIELDS SEARCHED (Int Cl.⁴)<br><br>H 01 L 21/30<br>H 01 L 29/78 |
| A | | 3,10 | |

--- -/-

The present search report has been drawn up for all claims

| Place of search | Date of completion of the search | Examiner |
|---|---|---|
| BERLIN | 24-10-1986 | PRETZEL B.C. |

| | **DOCUMENTS CONSIDERED TO BE RELEVANT** | | | Page 2 |
|---|---|---|---|---|
| Category | Citation of document with indication. where appropriate, of relevant passages | | Relevant to claim | CLASSIFICATION OF THE APPLICATION (Int Cl 4) |
| A | IEEE JOURNAL OF SOLID-STATE CIRCUITS, vol. SC-12, no. 3, June 1977, pages 264-270, New York, US; M. DECLERCQ et al.: "A theoretical and experimental study of DMOS enhancement/depletion logic" * page 269, conclusion * | | 7,8,11 | |
| | ----- | | | |
| | | | | TECHNICAL FIELDS SEARCHED (Int Cl 4) |

The present search report has been drawn up for all claims

| Place of search | Date of completion of the search | Examiner |
|---|---|---|
| BERLIN | 24-10-1986 | PRETZEL B.C. |